# EUROPEAN PATENT APPLICATION

(11) **EP 1 722 424 A1**
(43) Date of publication of application: **15.11.2006**
(21) Application number: 05447108.1
(22) Date of filing: 13.05.2005
(51) Int. Cl.: H01L 51/30

(54) **Method for the manufacturing of homeotropically aligned layer of discotic liquid crystals**

(71) Applicant: Université Libre de Bruxelles, 1050 Brussels (BE)
(72) Inventor: De Cupere, Vinciane, 1490 Court-Saint-Etienne (BE); Heintz, Christophe, 6700 Arlon (BE); Geerts, Yves, 1160 Brussels (BE); Tant, Julien, 1080 Brussels (BE)
(74) Representative: Van Malderen, Michel

(57) **Abstract**

The present invention relates to a method for the manufacturing of an homeotropically aligned layer of discotic liquid crystals comprising the steps of:
- depositing a layer of a discotic material on a substrate;
- depositing a sacrificial layer on said discotic layer;
- inducing the homeotropic alignment of the discotic material of the layer by a magnetic field or by thermal annealing;
- removing the sacrificial layer.

## Description

### Field of the invention

The present invention is related to microelectronics and more particularly to a method for the manufacturing of homeotropically aligned layers of discotic liquid crystals and to their use in electronic devices.

### State of the art

Discotic liquid crystalline materials are defined by Demus et al. in "Handbook of Liquid Crystals: vol . 1 Fundamentals", (1998), wiley-VCH. Liquid crystalline molecules are generally composed of a rigid aromatic molecular core surrounded by several flexible side chains. These materials are known for their ability to self-organize in columns, behaving as quasi-one dimensional semi-conductors (Boden N., Bushby R.S., Clement S., J. Chem. Phys., (1993), 98(7), 5920). Indeed, the stacking of the aromatic cores leads to the formation of conductive wires while the side chains act as an insulating coating, allowing the charges and the excitons to move only along the columnar axis.

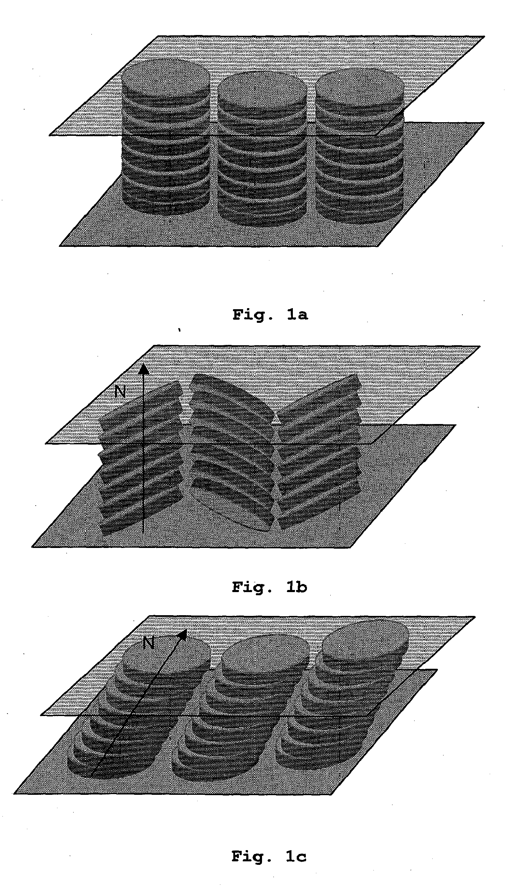

It has been shown that, due to this anisotropy, the long range conductivity of such materials strongly depends on the molecular organization in the devices. The best configuration is obtained when the columnar axis is perpendicular to the substrate(s) (Figures 1a and 1b), or when the optical director of the material forms an angle of 70° to 90° with respect to the substrate(s) surface(s) (Figure lc). In the case of devices such as Organic Light Emitting Devices (OLED's), Photovoltaic Cells (PVC's), sensors, ..., this homeotropic alignment is for far the preferred molecular organization.

In devices, organic active layers are generally deposited from solutions or by vapor deposition; the obtained films then possess an interface in direct contact with air. They are characterized by a thickness in the order of a few tens of nanometers with such geometry, some molecules like triphenylene derivatives spontaneously adopt an homeotropic alignment during the deposition process or during annealing (Sergan et al, 2001; Eichhorn et al, 2003; Schonherr et *al*, 2002). Hexabenzocoronene and phthalocyanine derivatives have intermediate behavior since some studies report the observation of homeotropic alignment (Friedlein et *al*, 2004; Hatsusaka et *al*, 2000) while others articles show disordered or homogeneous organization (Critchley et *al,* 1992, Basova et al, 2002).

For all the molecules which do not spontaneously develop homeotropic alignment, it exists an important need for the development of procedures that allow the obtaining of this suitable organization. For phthalocyanine for example, experimental observations made in our lab indicate that columns oriented perpendicularly with respect to the film surfaces are obtained more easily when the molecules are sandwiched between two substrates and thermally annealed, suggesting that the interface with air is detrimental for the development of homeotropic alignment.

Here, we disclose a method for manufacturing homeotropically aligned discotic liquid crystalline films using a sacrificial layer to avoid contact with air during annealing. After the obtaining of homeotropic alignment, the sacrificial layer is removed, allowing the subsequent deposition of other active organic layers or electrodes

### Aims of the invention

The present invention aims to provide a method for the manufacturing of homeotropically aligned layers of discotic liquid crystals and their use in electronic devices.

Furthermore, the present invention discloses a sacrificial layer acting as removable top substrate on a layer of discotic mesogen, the induction of homeotropic alignment of said layer, and finally the removal of the top sacrificial layer.

### Summary of the invention

The present invention discloses a method for the manufacturing of an homeotropically aligned layer of discotic liquid crystals comprising the steps of:
- depositing a layer of a discotic material on a substrate;
- depositing a sacrificial layer on said discotic layer;
- inducing the homeotropic alignment of the discotic material by a magnetic field or by thermal annealing;
- removing the sacrificial layer.

According to particular embodiments, the present invention comprises one or several of the following features:
- the homeotropically aligned discotic layer is 2,9 (10), 16 (17), 23 (24) -Tetra (2-decyltetradecyloxy)-phthalocyanine;
- the sacrificial layer consist in organic polymer;
- the sacrificial layer is selected from the group of poly (4-vinylphenol), poly (2-vinylpyridine), poly(4-vinylpyridine);
- the layer of discotic material is realized from a solution, using solvent-based deposition techniques selected from the group consisting of spin-coating, doctor blading, drop-casting, inkjet, contact, or wave printing techniques.
- the sacrificial layer is deposited from a solution, using solvent-based deposition techniques selected from the group consisting of spin-coating, doctor blading, zone-casting, drop-casting, or the inkjet, contact, or wave printing techniques;
- the sacrificial layer fully covers layer 2;
- the sacrificial layer is patterned;
- the homeotropically aligned discotic layer is covered by additional layers; .
- the sacrificial layer is removed by dissolution in a solvent wherein the discotic material is not soluble;
- the discotic material is selected from the group consisting of p-type discotic materials;
- the discotic material is selected from the group consisting of n-type discotic materials;
- the thickness of the layer of discotic material is between 20nm and 10µm.

The present invention also discloses the use of homeotropically aligned layer of discotic liquid crystals realized according to the method of Claim 1 in electronic devices as well as the use of sacrificial layer to induce the homeotropic alignment of the discotic material of the layer by a magnetic field or by thermal annealing.

### Short description of the drawings

Fig. 1 shows the most suitable organizations of the columns in electronic devices: a) homeotropic alignment (optical director, N, perpendicular to the substrates, discotic molecules perpendicular to the columnar axis), b) director, N, perpendicular to the substrates, discotic molecules tilted in the columns, c) director, N, forming a 70 to 90° angle with respect to the substrate, molecules perpendicular to the columnar axis.

Fig. 2 represents the different steps of the present invention, resulting in a fully homeotropically aligned layer of discotic material. '

Fig. 3 represents the different steps of the present invention, resulting in a patterned homeotropically aligned layer of discotic material.

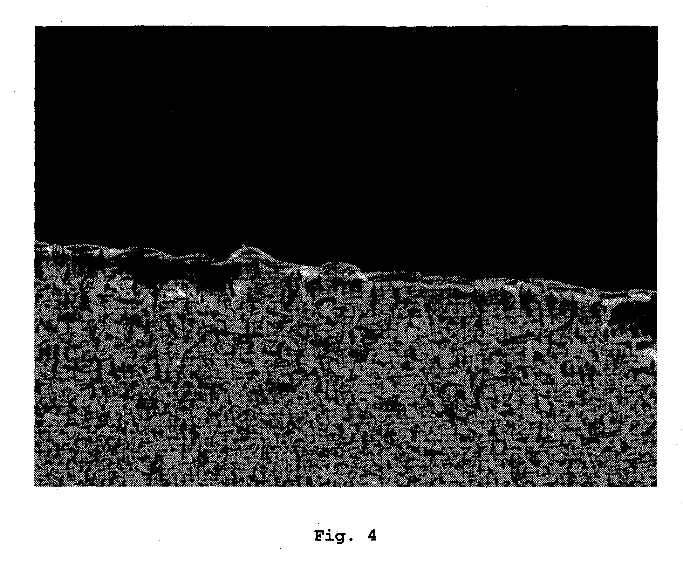

Fig. 4 represents a phthalocyanine derivative film annealed under a poly(vinylphenol) sacrificial layer for the upper part, and in contact with air for the lower part. Image obtained by light microscopy under crossed polarizers.

### Detailed description of the invention

The present invention relates to a method for the manufacturing of homeotropically aligned layer of discotic materials via the use of a sacrificial layer.

On a substrate 1, is deposited a layer 2 of discotic material. A second layer 3, the sacrificial layer, is then deposited on the top of the mesogenic material. A treatment is applied to the sandwiched liquid crystal layer to obtain homeotropic alignment. It can consist in thermal annealing, exposure to magnetic field or a combination of them. After obtaining of the homeotropic alignment, the sacrificial layer 3 is removed. The removal of the layer can be performed by dissolution or mechanical peel-off. A layer 4 can be deposited on layer 2 in order to build a functional device.

The substrate 1 is basically a flat substrate coated with an electrode. Typical materials for electrode layers are metals like gold, silver, aluminum, magnesium, ... azad/or metal oxides like tin oxide, indium tin oxide, zinc oxide, indium zinc oxide, titanium oxide, gallium oxide, yttrium oxide, terbium oxide, praseodymium oxide, ... inorganic salts like lithium fluoride (LiF), cesium fluoride (CsF), lithium oxide (Li₂O), ... are also possible candidates organic materials such as conjugated polymers are other candidates. Non-restrictive examples are PEDOR (poly[3,4-(ethylene-1,2-dioxy)thiophene]) PEDOT-PSS, polyaniline, polypyrrole, polythiophene, substituted or not, cross-liked or not. They have to be chosen according to their work function, roughness, solubility, .... These electrodes are well known by those who are skilled in the art.

The substrate can be glass, quartz, silica, silicon, mica or organic polymers. The latest have to be chosen to resist to the treatments applied to obtain homeotropic alignment and to remove the sacrificial layer. If thermal annealing is applied, polymer substrate 1 has to be stable (no chemical degradation nor physical modification) at the annealing temperature. If the removal of the sacrificial layer is performed by dissolution, the polymer substrate 1 has to be non soluble in the solvent used. These substrates are well known by those skilled in the art.

The nature of the discotic material of layer 2 depends on the specific use and on the chemical nature of the layers 1 and 4. The semiconductor can be of n-type if high electrons (negative charges) conductivity is needed. Non exhaustive examples of n-type discotic semiconductors are derived from the hexaazatriphenylene, hexaazatrinaphthylene, dodecaazatrinaphthylene, hexaazatriisooxanaphthene, hexaazatriisothianaphthene, tricycloquinazoline, perylo[1,12-efg] isoindole-1,3-dione, tetraaza-tetrahydrocoronene-tetracarboxylic acid bisphenylimide, terylene, quaterylene, perinone bisbenzimidazole, perylene, pyrene, ... aromatic cores, substituted with flexible side-chains.

If high holes (positive charges) conductivity is needed, the discotic material will be taken in the family of the p-type semiconductors. Non exhaustive examples of such materials are derived from the triphenylene, hexabenzocoronene, phthalocyanine, porphyrin, tetraazaporphyrin, ... aromatic cores, substituted with flexible side-chains.

Preferred methods for the depositing of the discotic material of the layer 2 are solution based coating techniques such as spin-coating, doctor blading, drop-casting, inkjet printing, ... or any variant of those. In this case, if the electrode is constituted by an organic material, the latest needs to be resistant to the solvent used to prepare the liquid crystal solution.

Layer 3 consists in a polymer which can be deposited from a solution comprising a polymeric or a polymerizable material dissolved in a solvent. The solvent must be compatible with the mesogenic material 2 and with the substrate 1 (no dissolution or deterioration of them). If a polymerizable material is used, a polymerization step is required for the formation of the sacrificial layer 3 on the top of the discotic layer 2.

If thermal annealing is used, the polymer has to display a vitreous-glass transition temperature in the same order or higher than the annealing temperature, in order to preserve the film integrity. The control of the coverage of the liquid crystal layer by the polymer requires the use of concentrated solutions and high molecular weight materials.

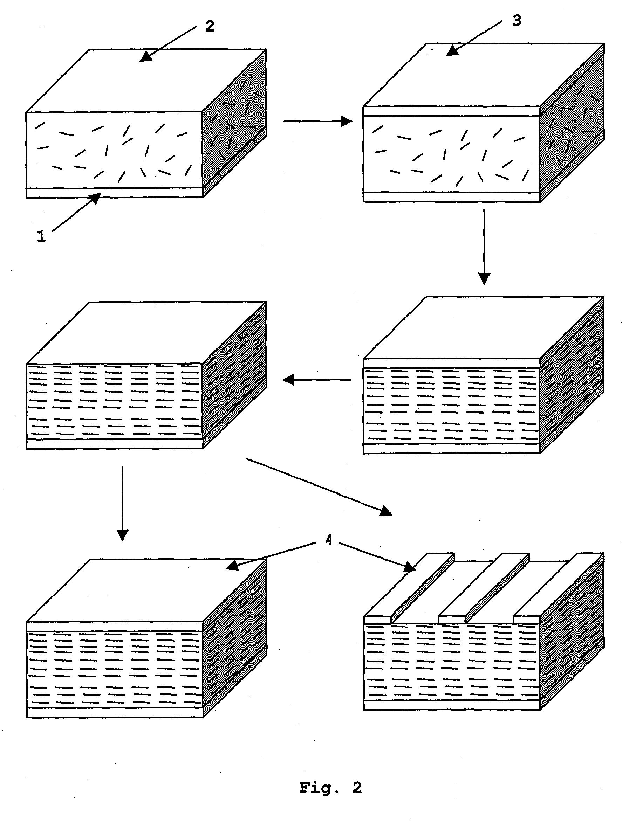

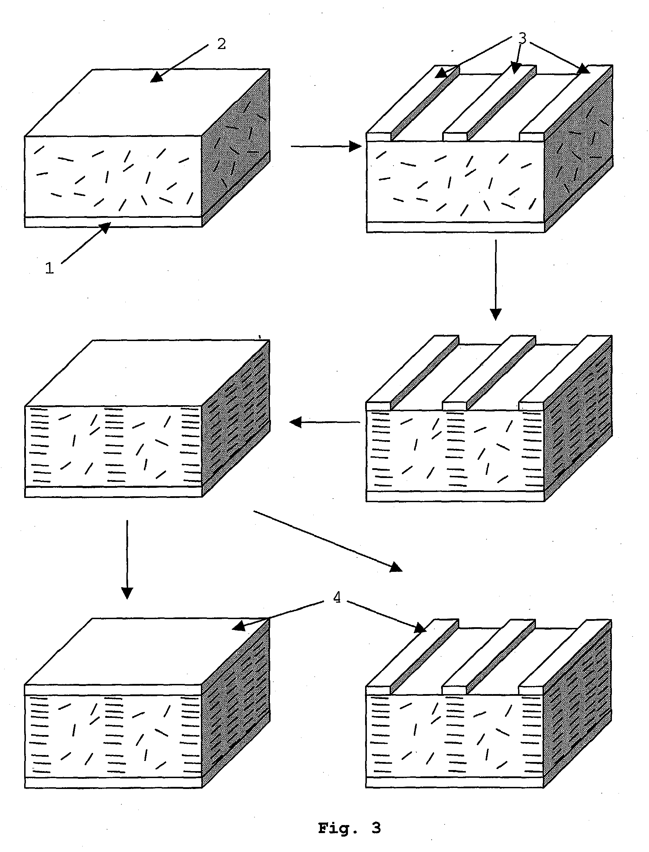

Preferred methods for depositing layer 3 are solution-based methods (among which: spin-coating, doctor blading, zone-casting, drop-casting, inkjet printing, contact printing, wave printing, ... or any variant of those). The resulting layer 3 can consist in a continuous film of material (where the material is uniformly spread on layer 2, see Fig. 2) or in a patterned film (where certain zones of layer 2 are not covered by the material, see Fig. 3 for an example) .

When the discotic material 2 is sandwiched between the substrate 1 and the sacrificial layer 3, it can be homeotropically aligned by thermal annealing. The device is heated to a temperature at which the discotic material is in its isotropic liquid phase or become fluid enough to allow molecular reorganization. It is typically in a range between 50 and 250°C. The device is then cooled down, continuously or not, with or without gradient of speed, resulting in homeotropically aligned layer of the discotic material composing layer 2. The use of an oriented magnetic field and/or of a gradient of temperature may be needed in some cases.

When the discotic material composing layer 2 has been homeotropically aligned between substrate 1 and layer 3, this last has to be removed ("sacrificed"). The removal can be achieved mechanically (by stripping off or by lifting off the layer) or by dissolving the material composing layer 3 in a solvent, pure or not. The choice of the solvents used highly depends on the solubility characteristics of the sacrificial layer, of the discotic material 2, and of the substrate 1, while the two last have to be unaffected by the removal of layer 3. Such solvents have to be chosen according to the system and are known by those skilled in the art. The washing can be repeated several times, under different experimental conditions (solvent composition, temperature, atmosphere, flux, etc.) to ensure all the material composing the sacrificial layer is removed.

The nature of layer 4 will depend on the nature of the layer 2 and on the device application. It can consist in more than one layer of organic or inorganic material, or of any combination of those. Each layer composing the globally called "layer 4" can independently act as insulator, semiconductor, or conductor, depending on the needs. Layer 4 also includes a possible additional substrate of the same nature as substrate 1, and/or an encapsulation coating used to protect the device, mechanically (against scratches, breaks, ...), chemically (against water, oxygen, solvents, light, ...), and/or physically (against electrostatic charges, magnetic fields, ...) , ... .

In the case of photovoltaic devices, layer 4 can comprise three sub-layers: an organic or inorganic semiconductor, an organic or inorganic electrode, and a hard or flexible substrate. The semiconductor has to show complementary characteristics to layer 2: if the material used in 2 is of n-type, the material of the first sub-layer of layer 4 has to show an electron donor character (p-type), and vice versa. It will preferably consist in a conjugated polymer, a crystalline or liquid crystalline material, or in a metal oxide. These materials are well known by those skilled in the art. An electrode is needed to collect the charges produced at the interface between the two semi-conducting layers (layer 2 and the first sub-layer of layer 4). It will preferably consist in a conjugated polymer or in a metal or in a metal oxide. The optional substrate acts as protecting layer.

In the case of OLED's, they will also include an electroluminescent layer. This layer will consist in an organic or inorganic material that has to be both electrons and holes acceptor, and that is luminescent. Non-restrictive examples of such electroluminescent materials are conjugated polymers, crystalline and liquid crystalline materials, etc.

The different sub-layers composing can be independently cast using, for each sub-layer, dry or solvent-based deposition techniques. Some examples of dry techniques are the mechanical coating, the vacuum and vapor deposition, the deposition of the material in its melted phase, etc. Non-restrictive solvent-based methods are spin-coating, doctor blading, zone-casting, drop-casting, inkjet printing, contact printing, wave printing, .... These additional layers have to be deposited with a solvent that cannot dissolve the material composing the previous layers.

When the desired device structure is achieved, the electronic component/device can be optionally encapsulated.

### General operating mode of the present invention

A solution of a discotic material, insoluble in high polarity solvents, is made. In order to increase the solution concentration, the solvent can be heated up to reflux. The solution (hot or cold) is spin-cast on a substrate 1 consisting in a flat surface as defined above, cast with a 10nm to 1µm thick film of metal or metal oxide that acts as electrode. The thickness, regularity, and roughness of layer 2 is regulated by the general spinning conditions, the solution concentration and the nature of the solvent.

The spinning rate is generally chosen between 500 and 5000rpm with or without acceleration. It can be performed under air, solvent vapor, or inert atmosphere, according to the needs. Under these conditions, a good quality film (layer 2) is obtained, with a thickness range of 20nm to 1µm.

A solution of a polymer, soluble in high polarity solvent, is made. In order to increase the solution concentration, the later can be heated up until reflux. The solution is spin-cast on the top of layer 2, using a spinning rate of 500 to 5000rpm with or without gradient of speed or acceleration. Under these conditions, a good quality film (layer 3) is obtained on the top of (layer 2), with a thickness range of 200nm to 10pm.

According to the invention, the device is treated in order to induce an homeotropic alignment of the columns of discotic molecules between the substrate 1 and the polymer layer 3. The device is preferably heated up to a temperature at which the discotic material is in its isotropic liquid phase or is fluid enough to allows for reorganization, but where the different components composing the device are still thermally stable. This temperature highly depends on the discotic material used, the experimental conditions, and to the nature of the substrate 1 and the polymer layer 3. Annealing temperatures above 250°C have to be avoided to minimize thermal degradation. The device is left at high temperature in order to let the system reach its equilibrium state. It is then cooled down to the lower temperature phases of the discotic material. All this process is preferably done under nitrogen atmosphere, at ambient pressure (around 1 bar).

The layer 3 is removed by dissolving the polymer in a high polarity solvent such as water, methanol, ethanol, acetone, ...; solvents that can not dissolve the discotic material of layer 2, nor the substrate 1. The device is washed several times with high polarity solvents, hot or cold, wherein the polymer is soluble but not the discotic material. The resulting device can be optionally further cleaned by use of an ultrasonic bath. According to the needs, different solvents or mixture of them can be used.

The additional sub-layers composing layer 4 are then deposited according to the needs.

### Example 1:

### Manufacturing of an homeotropically aligned film of discotic material by use of a sacrificial poly(vinylphenol)layer

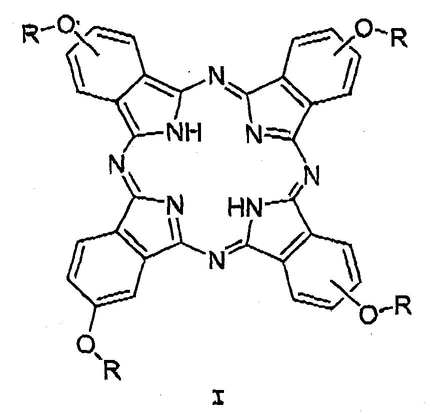

30g of the discotic material 2,9 (10), 16 (17), 23 (24)-Tetra(2-decyltetradecyloxy)-phthalocyanine (I with R is 2-decyltetradecyl) are dissolved in 1 L of toluene.

A layer of discotic materials (about 80nm thick) is spin-cast on a quartz substrate (rotation speed: 1500rpm; spinning time: 60 seconds; acceleration: 150rpm/second) . The sample is left to dry for 2 hours at 70°C or one night at room temperature. A solution of 10g of poly-4-vinylphenol in 0.126 L of methanol is made. A layer of polymer is spin-cast on the discotic material (rotation speed: 6000rpm; spinning time: 40 seconds; acceleration: from 0 to 1500rpm in 6sec, from 1500 to 4000rpm in 10 sec and from 4000 to 6000 in 30 sec.

The resulting device is heated at 20°C/minute up to 140°C, where the discotic material **I** starts to aligned homeotropically; at 160°C the entire film has gained the expected organization. The device is then cooled down at 20°C/minute to 25°C, resulting in a fully homeotropically aligned layer of **I**.

The polymer layer is removed by carefully washing the device in 5 successive 30-sec methanol baths, solvent that selectively dissolves the poly-4-vinylphenol and does not affect the discotic material **I**.
It results from this process the formation of an 80nm-thick homeotropically aligned layer of the discotic material **I** on only one substrate.

### Example 2:

### Manufacturing of an homeotropically aligned film of discotic material by use of a sacrificial poly(4-vinylpyridine) layer

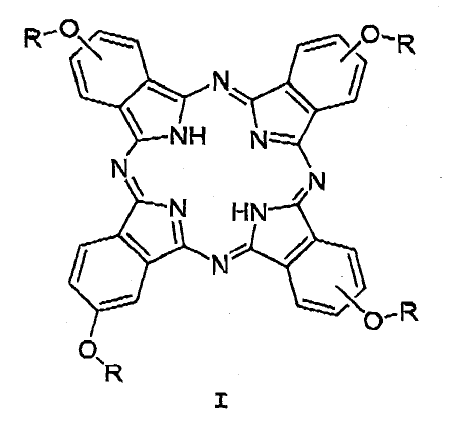

30g of the discotic material 2, 9 (10),16 (17),23 (24)-Tetra(2-decyltetradecyloxy)-phthalocyanine (**I** with R is 2-decyltetraclecyl) are dissolved in 1 L of heptane.

A layer of discotic materials (about 200nm thick) is spin-cast on a quartz substrate (rotation speed: 1500rpm; spinning time: 60 seconds; acceleration: 150rpm/second). The sample is left to dry for 2 hours at 70°C or one night at room temperature. A solution of 10g of poly(4-vinylpyridine) in 0.126 L of methanol is made. A layer of polymer is spin-cast on the discotic material (rotation speed: 6000rpm; spinning time: 40 seconds; acceleration: from 0 to 1500rpm in 6sec, from 1500 to 4000rpm in 10 sec and from 4000 to 6000 in 30 sec.

The resulting device is heated at 20°C/minute up to 140°C, where the discotic material I starts to aligned homeotropically; at 160°C the entire film has gained the expected organization. The device is then cooled down at 20°C/minute to 25°C, resulting in a fully homeotropically aligned layer of **I**.

The polymer layer is removed by carefully washing the device in 5 successive 30-sec methanol baths, solvent that selectively dissolves the poly-4-vinylpyridine and does not affect the discotic material **I**.

It results from this process the formation of a 200nm-thick homeotropically aligned layer of the discotic material **I** on only one substrate.

**Legend**
1. substrate
2. layer of discotic mesogenic material
3. sacrificial layer
4. additional layer(s)

## Claims

1. Method for the manufacturing of an homeotropically aligned layer of discotic liquid crystals comprising the steps of:
- depositing a layer of a discotic material (2) on a substrate (1) ;
- depositing a sacrificial layer (3) on said discotic layer (2) :
- inducing the homeotropic alignment of the discotic material of the layer (2) by a magnetic field or by thermal annealing;
- removing the sacrificial layer (3).

2. The method of Claim 1, wherein said homeotropically aligned discotic layer (2) is 2,9(10),16(17),23(24)-T-otra(2-decyltetradecyloxy)-phthalocyanine.

3. The method of Claim 1, wherein the sacrificial layer 3 comprises an organic polymer.

4. The method of Claim 3, wherein said sacrificial layer is selected from the group of poly(4-vinylphenol), poly(2-vinylpyridine), poly (4-vinylpyridine) .

5. The method of Claim 1, wherein the layer of discotic material is realized from a solution, using solvent-based deposition techniques selected from the group consisting of spin-coating, doctor blading or drop-casting.

6. The method of Claim 1, wherein the sacrificial layer is deposited from a solution, using solvent-based deposition techniques selected from the group consisting of spin-coating, doctor blading, zone-casting, drop-casting, or the inkjet, contact or wave printing techniques.

7. The method of Claim 1, wherein the sacrificial layer fully covers layer (2).

8. The method of Claim 1, wherein the sacrificial layer is patterned.

9. The method of Claim 1, wherein said homeotropically aligned discotic layer (2) is covered by additional layers (4) .

10. The method of Claim 1, wherein the sacrificial layer is removed by dissolution in a solvent wherein the discotic material is not soluble.

11. The method of Claim 1, wherein the discotic material is selected from the group consisting of p-type discotic materials.

12. The method of Claim 1, wherein the discotic material is selected from the group consisting of n-type discotic materials.

13. The method of Claim 1, wherein the thickness of the layer of discotic material is between 20nm and 1µm.

14. Use of homeotropically aligned layer of discotic liquid crystals realized according to the method of Claim 1 in electronic devices.

15. Use of sacrificial layer as in Claim 4 to induce the homeotropic alignment of the discotic material of the layer (2) by a magnetic field or by thermal annealing.
